# EUROPEAN PATENT APPLICATION

(11) **EP 4 481 889 A1**
(43) Date of publication of application: **25.12.2024**
(21) Application number: 23180162.2
(22) Date of filing: 19.06.2023
(51) Int. Cl.: H01M 10/48, H02J 7/00

(54) **A COMMUNICATIONS SYSTEM FOR MONITORING AN ELECTRIC BATTERY SYSTEM**

(71) Applicant: Dukosi Limited, Edinburgh EH3 8RA (GB)
(72) Inventor: MCVEIGH, Gavin, Edinburgh, EH3 8RA (GB); SYLVESTER, Joel, Edinburgh, EH3 8RA (GB)
(74) Representative: Finnegan Europe LLP

(57) **Abstract**

The present disclosure relates to a communications system for monitoring an electrical battery system. The communications system is a multitiered system with distinct Time-Division-Multiple-Access (TDMA) for respective levels.

## Description

### BACKGROUND

Battery systems, comprising a plurality of battery cells, are used in a wide range of modern electric power applications. For example, they are used to power electric vehicles, they are used in industrial power applications, in transportation, and in commercial applications such as powering of modern electronic devices. Given the relatively high-power demands of such applications, a battery system often comprises a plurality of battery cells coupled together to achieve the required power output. The battery cells may be coupled together to form a battery pack, and the battery system may comprise one or more battery packs.

It is common to connect a battery system to a battery management system (BMS), configured to ensure that the battery system operates within its safe operating area. The safe operating area is defined as the voltage and current conditions and environmental conditions under which the battery system is expected to operate without self-damage. For further details, the interested reader is directed to the following Wikipedia website: https://en.wikipedia.org/wiki/Battery_management_system.

In certain known applications, performance characteristics of the battery cells within the battery system may be monitored, to identify potentially faulty operation of cells within the battery system before a catastrophic fault occurs. Such measurements are made with the use of devices called a Cell Monitoring Device (CMD). CMDs provide cell-level measurements such that separate measurements are taken on individual cells and the information obtained is with respect to an individual cell. Further measurements may be obtained using an auxiliary device which may obtain measurements from a grouping of cells or on the battery pack level. Measurements taken by a CMD and/or auxiliary device are typically transmitted through the battery management system towards a central controller.

### SUMMARY

To properly maintain and regulate the electric battery system, measurements need to be obtained with high accuracy. However, as the electric battery system scales to larger sizes, latency issues may arise because of measurements and/or communications traveling greater distances throughout the battery management system. As such, a system is needed for improved communications within a battery management system.

Example embodiments presented herein comprise a communications system for monitoring an electrical battery system. The communications system comprises a single Time-Division-Multiple-Access (TDMA) protocol operating across the communications system. The communications system further comprises a plurality of electronic devices situated on a first level of the communications system, wherein each electronic device is configured to obtain measurements on at least one respective battery cell of the electrical battery system, where the plurality of electronic devices are arranged in at least two subgroups of electronic devices. It should be appreciated the electronic device may be in form of a CMD, an auxiliary device, or any other component capable of taking a cell or battery related measurement or controlling a cell or battery related functionality. It should further be appreciated the term `at least one respective battery cell' shall include an individual battery cell, a plurality of battery cells of a battery pack.

The communications system further comprises at least two radio manager units situated on a second level of the communications system, wherein each subgroup of electronic devices is in communication with a respective radio manager unit via a first TDMA schedule and over a first communications medium. The communications system further comprises at least one radio director unit situated on a third level of the communications system, wherein each radio manager unit and the at least one radio director unit are in communication via a second TDMA schedule and over a second communications medium.

The at least one radio director unit is configured to determine the second TDMA schedule and each radio manager unit is configured to determine the respective first TDMA schedule, where the first and respective second TDMA schedules define a timing for measurement based reporting and instruction messaging throughout the communications system in a synchronized manner.

Example embodiments are also directed towards a method in a communications system for monitoring an electrical battery system, where the communications system operates across a single Time-Division-Multiple-Access (TDMA) protocol. The method comprises determining a first TDMA schedule for communications, over a first communications medium, between a plurality of electronic devices and at least two radio manager units, where the plurality of electronic devices are situated on a first level of the communications system and are arranged in at least two subgroups of electronic devices. The at least two radio manager units are situated on a second level of the communications medium.

The method further comprises determining a second TDMA schedule for communications, over a second communications medium, between the at least two radio manger units and at least one radio director unit, where the at least one radio director unit is situated on a third level of the communications system. The method also comprises obtaining, via the plurality of electronic devices, measurements on at least one respective battery cell of the electrical battery system. The method additionally comprises transmitting, to at least two respective radio manager units, the obtained measurements the via the first TDMA schedule and over the first communications medium. The method also comprises further transmitting, to the at least one radio director unit, the obtained measurements via the second TDMA schedule and over the second communications medium. The at least one radio director unit is configured to determine the second TDMA schedule and each radio manager unit is configured to determine the respective first TDMA schedule, where the first and respective second TDMA schedules define a timing for measurement based reporting and instruction messaging throughout the communications system in a synchronized manner.

The Example embodiments are also directed towards a computer-readable medium storing instructions which, when executed by a processor of a communications system for an electronic battery system, cause the communications system to execute methods described herein.

### BRIEF DESCRIPTION OF THE DRAWINGS

The foregoing will be described in more detail with the following more particular description of the example embodiments, as illustrated in the accompanying drawings in which reference characters refer to the same parts throughout the different views. The drawings are not necessarily to scale, emphasis instead being placed upon illustrating the example embodiments.
**FIG. 1** is an illustration of measuring, monitoring and controlling components within a battery monitoring system;
**FIGS. 2-4** are illustrative examples of a communications system within a battery monitoring system;
**FIG. 5** is an illustration of a communications system within a battery monitoring system, according to some of the example embodiments presented herein;
**FIG. 6** is an illustrative example of a switching mechanism associated with the radio manager unit, according to some of the example embodiments presented herein;
**FIG. 7** and **FIG. 8** are an illustrative examples of messaging sequence diagrams of the communications system of **FIG. 5****,** according to some of the example embodiments presented herein; and
**FIG. 9** is an illustrative example of a multi-layered communications system within a battery monitoring system, according to some of the example embodiments presented herein.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

A means for providing a communication system for a battery monitoring system is described herein. A battery monitoring system may be comprised within an electric vehicle and/or an electric battery storage means. An overview of battery monitoring systems will be provided for context. A battery system typically comprises multiple cells wired in a configuration to provide the desired battery system voltage and capacity and additional parts necessary for the safe operation of the cells and transfer of energy to/from the cells. A cell is the basic unit of any battery system. The defining characteristic of a cell is its electrochemical characteristics. For a particular cell chemistry, there is a minimum, typical and maximum voltage that is determined by the electrochemistry of the cell, rather than the configuration of the system. The voltage cannot be varied other than by changing the electrochemical state of the cell. Cells may be wired in parallel, to increase the overall capacity, but these paralleled cells can simply be regarded from a cell monitoring perspective as a larger single cell since they still have the same voltage characteristics as determined by the electrochemistry.

Cells can also be wired in series. The series stack of cells has a voltage primarily determined by the stack configuration. The stack voltage will be the sum of the cell voltages. The stack voltage can be varied by adding or removing cells without changing their electrochemical state. Typically, the stack of cells will be charged and discharged, with their electrochemical state changing in tandem. Each cell must be monitored to ensure it stays within its safe operating area. This is the job of the cell monitoring device (CMD). CMDs provide cell-level measurements such that separate measurements are taken on individual cells and the information obtained is with respect to an individual cell.

A battery pack consists of multiple cells in series. The battery pack provides the full battery system voltage. Multiple battery packs may be wired in parallel to increase the battery system capacity, but not in series. The cells may be grouped into modules. The defining characteristic of a module is its physical configuration, for example, the number and connectivity between a number of cells. A module may comprise of any number of cells. A module comprises of two or more cells, or an entire pack. In the case of there being only a single pack in the battery system, then a module could encompass an entire battery system.

More often though, a pack is configured as multiple modules, where each module is configured from multiple cells in series. Multiple modules are then wired in series, or in parallel, or a combination of series and parallel. Modules that are the battery system voltage and are wired in parallel may be considered as packs. A module has a defined size, shape and is typically packaged in an enclosure of some kind.

The module configuration is driven by the physical requirements of the battery pack. Often a module is configured to have a low enough voltage that it can be handled without there being an electrical shock hazard. Often a module is configured for a number of cells that matches the number of voltage sense inputs on a cell monitoring device. A very common example is a twelve cell monitoring device. A module then consists of twelve cells and a connection to a cell monitoring device. In many battery packs, the properties of the CMD define the configuration of a module, and the battery pack is then built from multiple such modules.

While a CMD may be used to obtain cell-level measurements of the battery system, an auxiliary device may be used to obtain measured associated with a number of cells a module, pack and/or electric battery system. The auxiliary device provides module-level, pack-level and/or system measurements and may be flexibly placed anywhere within an electric battery system. The term `electronic device' is used herein as a device which provides measurements in the electric battery monitoring system. It should be appreciated the electronic device may be a CMD, an auxiliary device or any other device situated within the battery system that is capable of obtaining a measurement or providing control.

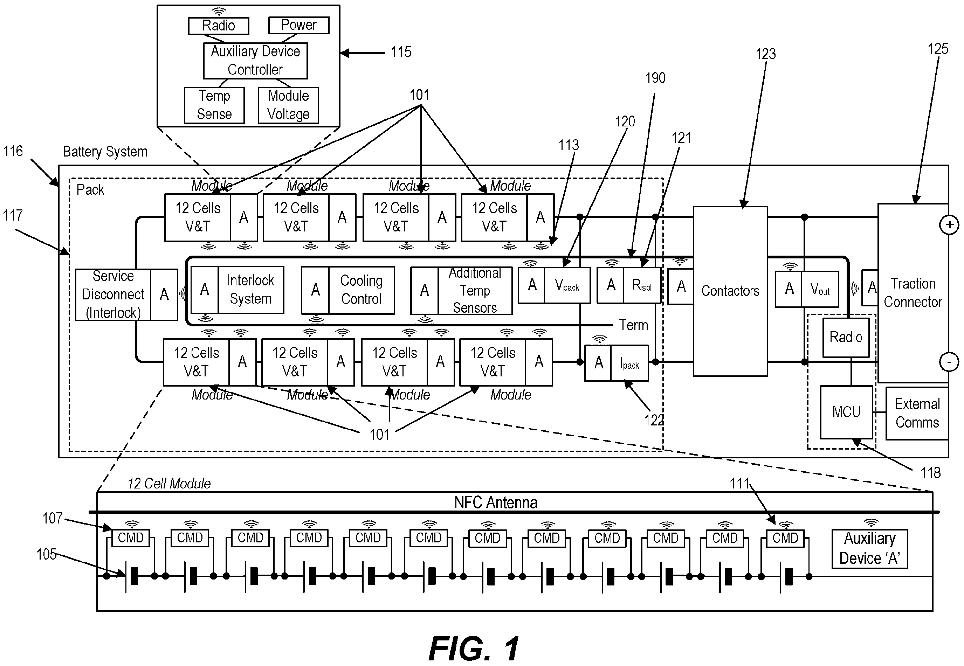

Figure 1 illustrates an example electric battery system featuring an auxiliary device 115 as well as various CMDs 107. The electric battery system 116 of Figure 1 comprises a single battery pack 117 featuring eight battery modules 101. Each battery module 101 features twelve battery cells 105. Each battery cell 105 is monitored by a respective CMD 107, which provides cell-level measurements. Each CMD 107 is configured to communicate with a central controller or BMS via a near field communications bus 109. To enable such communications, each CMD comprises a respective near field antenna 111. It should be appreciated, while the example of Figure 1 illustrates near field radio communications, other forms of communication systems may be employed. For example, the electric battery system of Figure 1 may feature communication channels in the form of far field radio, optical and electrical buses such as controlled area network (CAN), Ethernet, an isolated serial peripheral interface (isoSPI), local interconnect network (LIN), Flexray, etc..

According to some of the example embodiments, an auxiliary device may be placed on or within the electric battery system to obtain a module-level or pack-level measurement. In the example provided in Figure 1, an auxiliary device A is located within an enclosure of each battery module 101. Such a placement allows for the auxiliary device to obtain module-level measurements of the battery system. It should be appreciated that an auxiliary device may be placed near a plurality of modules such that a single auxiliary device may obtain module-level measurements on a plurality of modules. In such an example embodiment, the auxiliary device may be located in between two adjacent modules, for example.

In the example provided by Figure 1, an auxiliary device A is also provided in a location allowing for pack level measurements to be obtained. Specifically, auxiliary device A 120, 121 and 122 provides an example of an auxiliary device featuring a pack voltage measurement sensor, a battery system isolation resistance measurement sensor and a pack current measurement sensor, respectively. A further example of a placement of an auxiliary device for obtaining pack-level measurements is provided in 123 where an auxiliary device is placed in proximity to a pack switch, commonly called contactors, and associated drive and sense circuitry. An auxiliary device A 124 may be configured to measure an output voltage of the battery pack. As a further example, an auxiliary device A may be placed in proximity to the main power connection to the battery system (traction connector) 125. The power connection includes a safety interlock switch which indicates the presence, or not, of the mating connector. Auxiliary device A on 125 is able to report the status of this safety interlock switch.

An enlarged view 115 of the auxiliary device A provides an example of features which may be comprised in the device. In the example provided in Figure 1, the auxiliary device A may comprise a temperature sensor and a voltage sensor. It should be appreciated the auxiliary device may comprise any number of or type of sensors used in monitoring an electric battery system. Examples of such sensors may be temperature, voltage, current, pressure, shock, gas, earth leakage, security/tamper detection, interlock status, fluid flow rate, gas flow rate, actuator position, fan/motor speed detector and/or other environmental sensors. The auxiliary device 115 may further comprise a radio frequency antenna 113 which is used to communicate with the central controller 118, or BMS, via the near field communication bus 109 in the same manner and using the same protocols as the individual CMDs.

Battery monitoring systems, such as the system illustrated in Figure 1, require communications systems to send messages and instructions to the various components of the monitoring system. There are various requirements for battery cell monitoring systems. For example, monitoring systems should be able to measure each cell voltage and optionally temperature to high accuracy. Furthermore, measurements are ideally made simultaneously on all cells, to facilitate comparison of performance between cells. Measurements should also be made with due care to ensure that data connections between cells are reliable and voltage isolation is maintained. Additionally, the system must be easy to manufacture and service. The system should also be scalable and latency issues shall be minimized for larger electric battery systems.

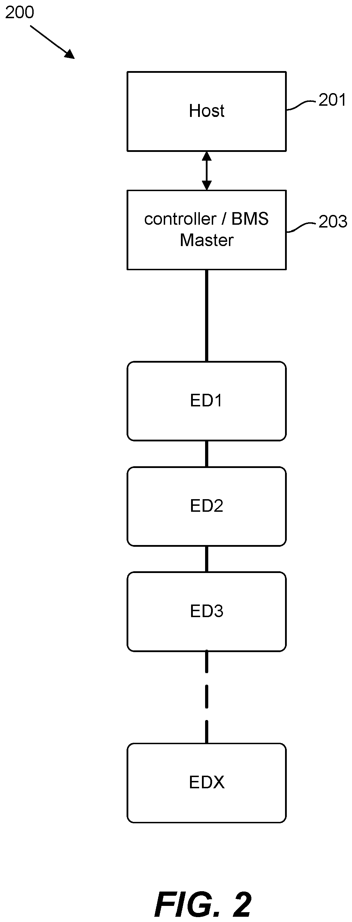

Figure 2 is an illustrative example of communications system 200 associated with a battery monitoring system known in the art. Figure 2 depicts Host 201 which represents the application the battery system is being used in, for example, a vehicle or stationary energy storage. Host 201 instructs controller or Battery Management System (BMS) Master 203. Controller 203 talks to a series of electronic devices (ED1-EDx), which make measurements on any number or grouping of lithium ion cells in the pack. Electronic devices may also provide an element of control, such as relays or contactors, or electronically triggered fuses, or thermal control. Electronic devices may be CMDs, auxiliary devices or any other node in the battery monitoring system which may make measurements on one or more cells, modules or battery packs. A typical electronic device measures 12 cells, and multiple electronic devices measure all the cells in the pack, say 96 cells or 192 cells. Thus, there may be 8 or 16 electronic devices in the system. The electronic devices are arranged in a daisy chain, where instructions from controller 203 to electronic devices are passed down the daisy chain, and the measured data is passed back up the daisy chain from the electronic devices. The daisy chain is typically implemented using a protocol such as an isolated Serial Peripheral Interface (isoSPI).

System 200 has a number of drawbacks. The latency, which is the time taken for a message to travel from controller to electronic device, or back, is different for each electronic device. Thus, it becomes difficult to synchronise all the electronic devices, such that the devices make measurements at exactly the same time.

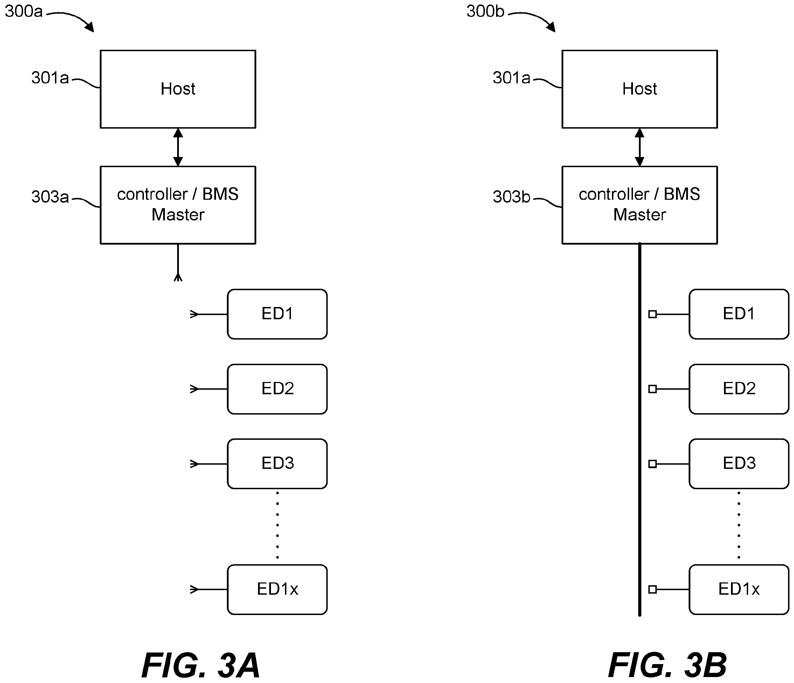

Figure 3a illustrates communications system 300a employing an alternative approach. Here the daisy chained communications is replaced with a radio frequency channel, for example, the 433MHz, 868MHz, 915MHz, 2.4GHz or 5.7GHz short range device (SRD) or industrial scientific medical (ISM) bands. The channel is configured with antenna at controller (now called Radio Manager or RM 303a) and at each of the electronic device (ED1-ED1x) to enable communications between electronic devices and Host 301a. This is sometimes known as a wireless BMS, as the communications are over a far field wireless link.

Communications system 300a has a number of advantages over the daisy chain approach illustrated in Figure 2. For example, the communications latency is constant between any pair of antenna (i.e., a single hop). Furthermore, there is a reduction in the number of cables and connectors. However, maintaining a single hop communications in the confines of a battery pack is very difficult. Often a cell cannot `see' the RM directly, and instead a message must be relayed via an intermediate cell. This is a mesh network solution. These are also undesirable as they increase and make the latency unpredictable. Additionally, there is still a problem with synchronising all the measurement times of the electronic devices.

Figure 3b shows a variation on the wireless BMS. Here the far field approach is replaced by a near field multi-drop approach. Each electronic device couples weakly to a bus antenna. This keeps the latency low and predictable. Furthermore, the latency is the same for all RM/electric device pairs using such an approach. The signal is conducted along the bus antenna, so there is no need for a multi-hop or mesh network.

The bus antenna in Figure 3b is typically a pair of wires configured as a transmission line. The bus antenna can reach many metres in length. A typical automotive pack may require a bus antenna that is 5 metres long. However, some applications demand a much longer bus antenna, for example, 20 metres or more. The longer the bus antenna, the greater the signal power losses are along it.

There will be a length where the losses in the bus antenna mean electronic devices located at the end of the bus antenna may not receive enough power. For example, the transmitter in the RM may put out -20dBm. There may be a 30dB attenuation across the near field gap to minimise electric device loading on the bus antenna. Other losses within the system may add up to 10dB. Thus, the total loss of the system may be provided as (-20-30-10) = -60dBm. The electronic device receiver may have a sensitivity, which is the minimum received signal strength, of -80dBm. This leaves room for a maximum of 20dB additional losses. The bus antenna may have 2dB of losses per metre. Thus, the maximum bus antenna length in this example is 20dB/2dB = 10metres.

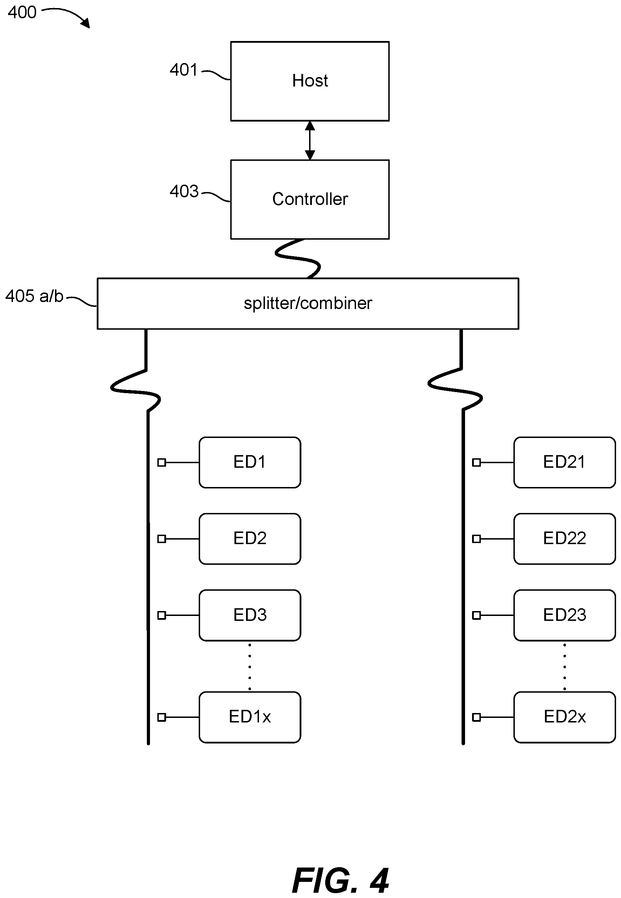

Figure 4 illustrates a communications system 400 in the form of a variation on Figure 3b, where the total length of bus antenna can be greater than would be indicated by the simple calculation described above. Splitter405a /combiner 405b component splits the RF signal from controller 403 between two bus antenna. The power in each bus antenna is reduced by 3dB (divided by two). However, the bus antenna need only be half as long as it only needs to cover half the cells. The second bus antenna sees the same power as the first.

There is no need for splitter 405a/combiner 405b to be at controller, and in large systems controller 403 and splitter 405a/splitter 405b may be some distance away from electronic devices. Electronic devices may be grouped into modules or racks, and the whole system may be the size of a shipping container or bigger. The Host 401 may also be some distance away.

Of course, a solution could be to have multiple electronic devices, all communicating to the host. But this re-introduces an earlier problem related to measurement synchronization. In order to properly maintain the battery monitoring system, it is useful for all the electronic devices to make their measurements at the same time, to within a few microseconds, for example.

Thus, example embodiments are presented herein provide a communications systems to be used with electronic battery monitoring where the communication losses due to the size of the system may be minimized. Furthermore, the communications system presented herein also provide fixed and short latency of communications which remove the need for hopping or identical latency hopping on all electronic devices. Additionally, the example embodiments presented herein provide for a synchronization of measurements across all the electronic devices in the system within the time frame of a microsecond. The example embodiments presented herein further provide a network formation at a single node (e.g., a controller or radio manager) for reliable and repeatable network formation time and identification of faults. The maintenance of isolation between sub-systems to high voltages (e.g., 500 VDC to 1500 VDC) is also provided as well as a low power milliamperes (mA) per node with microamperes (uA) sleep current.

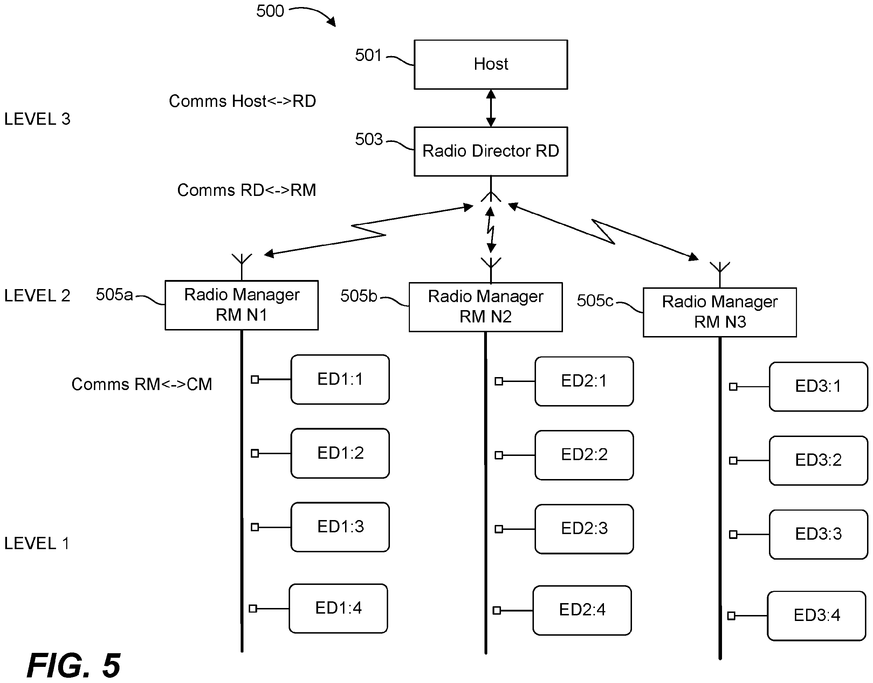

Figure 5 illustrates an electric battery monitoring communications system according to the example embodiments presented herein. Communications system 500 comprises a three level architecture. The first level comprises various groupings of electronic devices. The example of Figure 5 illustrates three distinct groupings with four electronic devices included in each grouping (ED1:1-ED3:4). The second level comprises a number of radio manager (RM) units 505a-505c. A distinct radio manager unit is associated with a respective grouping of electronic devices. In the example shown in Figure 5, RM unit 505a is associated with the first grouping featuring electronic devices ED1:1-ED1:4, RM unit 505b is associated with the second grouping featuring electronic devices ED2:1-ED2:4, and RM unit 505c is associated with the third grouping featuring electronic devices ED3:1-ED3:4. Radio director unit 503 is situated on a third level of the communications system and has direct communications with the Host 501.

It should be noted, the communications system of Figures 2-4 comprise a two level architecture where a controller or radio manager is situated between a host and electronic devices. Thus, the example embodiments presented herein increases the number of levels from two to three or more. Multiple electronic devices are grouped into branches, where each branch connected to one RM unit. Each grouping of electronic devices on the first level of the architecture is synchronized to an associated RM unit on the second level. Each RM unit on the second level of the architecture is in turn is synchronised to Radio Director 503 on the third level. The communications protocol is unified across all levels. RM units 505a-505c can switch from communicating with the level above it, to communicating with the level below it. The switch from one to the other happens in a time much less than the time taken to transmit a packet.

The highest level has at least one node. This is the Radio Director (RD) unit 503. At the start of a frame RD unit 503 broadcasts to the second level, RM unit(s) 505a-505c. The second level is timed with respect to the packet from the first level, and follows instructions contained in the RD unit broadcast. RM units 505a-505b broadcast to all respective electronic devices on the third level.

In operation, all components of Figure 5 will operate with a same communications protocol, for example a Time-Division-Multiple-Access (TDMA) protocol. However, the different architectural layers of system 500 will operate using distinct TDMA timing schedules. It should further be appreciated the different architectural layers of system 500 may also be comprised in different communications mediums, for example, far-field radio, near-field radio, optical, electromagnetic or any other form of communications medium. RM units 505a-505c, which are situated in the middle or second layer, have the functionality to switch between the distinct communications mediums of the different architectural layers. It should be appreciated, it is not necessary for different layers to comprise distinct communications mediums and the same mediums may be employed. In the example illustrated in Figure 5, the first level of the communications architecture comprises a near-field radio communications medium and the third layer of the communications architecture comprises a far-field radio communications medium.

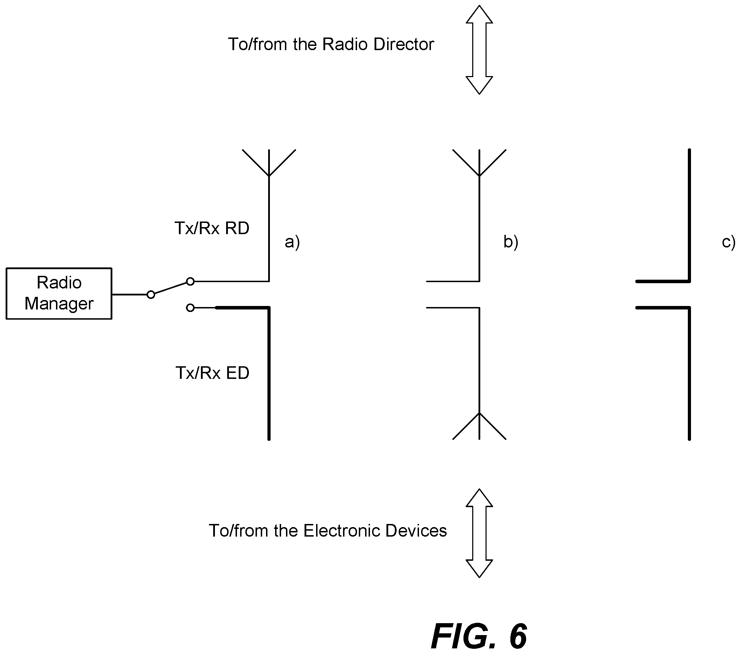

Figure 6 illustrates an example of a switching mechanism that may be comprised in each RM unit 505a-505c. RM unit 505a-505c switches between the two physical channels at a rate fast enough to maintain the synchronisation between EDs. If synchronisation can be maintained for 200ms, then a TDMA scheduling frame rate much less than 200ms is required to keep synchronisation. This may demand a frame rate of 10ms to 100ms.

The nature of the physical channel can vary. In the embodiment a) the RD<->RM layer (communications architecture level 3) is far-field radio, using a standard 2,4GHz antenna. The RM<->ED layer (communications architecture level 1) is a near field multi-drop bus antenna approach.

Other communications protocols, such as Bluetooth or IEEE802.11, also include a mechanism for synchronising the clocks of multiple nodes. However, these protocols cannot operate between more than two levels without buffering and loss of tight synchronisation. There are also mesh networks such as Bluetooth Mesh or SmartMesh which do operate across multiple levels or hops. However, these are non-deterministic, with variable latency and uncertain synchronisation due to not knowing a priori how many hops might be required for a message or synchronisation to reach all nodes. Mesh networks use a single antenna or channel for all links. While mesh networks may maintain the synchronisation across the layers such synchronization is difficult as the number of layers or hops is not deterministic. Specially, mesh networks may be synchronized at a high cost of communications and configuration overhead. Essentially, the variable latency has to be measured and compensated for. The synchronization achieved is hard to predict (not deterministic) and is generally worse than what may be actually achieved.

There are also radio systems that use multiple antenna for direction finding. These systems will rapidly switch between the antenna while maintaining coherency in the carrier wave (i.e., continuous phase for the carrier wave). The example embodiments presented herein do not demand coherency, the antenna switching is between packets transmissions, not during a packet transmission. Each packet is independent, and is received, or transmitted from, different transceivers depending on the switch state.

The example embodiments differ in that a single radio block is switched between two different physical channels. Embodiment a) is a good example, where the RD<->RM layer is far field, and the RM<->ED layer is a near-field bus antenna. Embodiment b) shows a far field antenna for both layers, this may be desirable if the two antennas are placed in different locations, perhaps on either side of a metal screen. Embodiment c) shows a wired (coaxial or twisted pair) RF connection from the RM<->RD, and near field bus antenna from RM<->ED. The physical nature of the radio link is not important, be it wired, near field, or far field. In each case though the modulated signal is transmitted and received by the same radio block on the RM.

It should be appreciated, the use of RM units 505a-505c featuring a switching mechanism is merely an example. A single radio at RM unit 505a-505c is not essential, using two radio blocks instead with no switching will work. However, the circuit will be larger and more complex. If two radio blocks were used, then they would not be operating at the same time in this method, so would be wasteful of circuit resources with no additional benefit.

According to the example embodiments RD unit 503 is configured to determine a TDMA schedule for communications between the third and second levels of the system architecture, namely between RD unit 503 and each RM unit 505a-505c. Similarly, each RM unit 505a-505c is configured to determine a TDMA schedule for each respective ED grouping. The TDMA schedules define a timing for measurement sample time, measurement reporting and instruction messaging through the communications system in a synchronized manner.

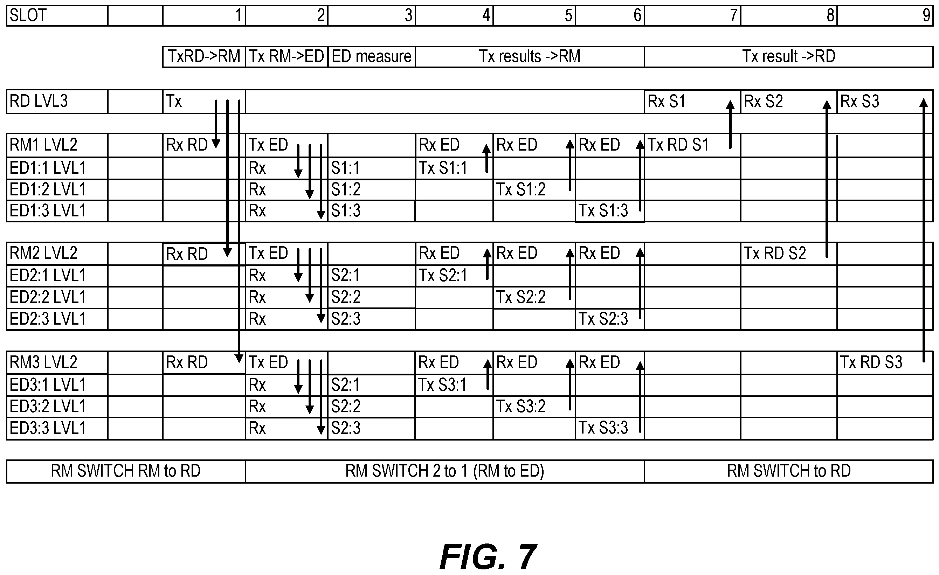

Figure 7 illustrates an example TDMA timing schedule which may be employed by communications system 500 of Figure 5. The communications timing is split into frames, where each frame is a complete instruct/synchronise/respond cycle. Each frame is divided into one or more slots. A frame is made up of multiple steps. The function and order of the steps is not critical, many arrangements will serve. The arrangement of Figure 5 is provided merely as an example. It should be appreciated, there is a RD to RM phase, which synchronises all the RM clocks, which set the time for the subsequent communications, and a RM to ED phase, which synchronises all the ED clocks, communications and measurements.

This synchronisation process can happen on every frame, or less often if the nodes stay in sync for longer. Synchronisation must happen often enough that all nodes stay within the specified timing error limits. It should be appreciated, that an intermediate layer (say an RM on layer 2 in a three layer system) is able to communicate both up to a higher layer (the RD on layer 3) and down to a lower layer (the ED on layer 1). It is advantageous for these communications to operate using the same radio circuit, but through different medium. In one example embodiment, there is a single radio block in the RD, RM and ED. In the RM, the radio input/output is switched between two media.

In the example provided by Figure 7, the first slot is a broadcast from the highest level (in this example, level 3) RD unit 503, to all RM units 505a-505c on level 2. All RM units 505a-505c will configure their antenna switches to level 3 to level 2, as denoted in Figure 7, slot 1 `RM SWITCH RM to RD'. Specifically, in Figure 7, slot 1, the RD (denoted as 'RD LVL3') sends a broadcast message denoted by a solid black line to all the RMs of Figure 5 (denoted as `RM1 LVL2', `RM2 LVL2' and `RM3 LVL2').

The first slot synchronises the communications for the rest of the frame, and instructs RM units on what responses RD unit expects to see in subsequent slots. There is no requirement for all ED and RM units to respond in a single frame, communications can be spread over multiple frames if necessary.

In the example of Figure 7, slot 2, all RM units 505a-505c switch communications to the first architecture level (denoted as `RM SWITCH 2 to 1 (RM to ED)') and transmit instructions to respective EDs. Each RM unit then broadcasts to all EDs connected on the same branch within a respective grouping. RM units 505a-505c instructs each ED which measurement to make (voltage, temperature, etc) and when to make it. Multiple measurements might be instructed, to be made at different times.

As instructed in the current example, all EDs make a measurement in slot 3, to gather the results. Specifically, in slot 3, EDs make their measurements and all measurements are synchronised to the reception of the broadcast packet timing in slot 2, which in turn was synchronised to the RD broadcast packet in slot 1. In slot 4, 5 and 6, EDs return their measurement results to their respective RM unit, one ED in each slot. It should be appreciated RM units are all able to communicate in parallel, as they are all switched to their respective channels. In slots 4, 5 & 6, each RM unit could operate on a different frequency, to avoid interference between RM/ED channels. RM units receive and store the results for transmission in a later slot. In slot 7, 8 & 9, RM units all switch their antennas back to the channel to RD unit 503. Each RM unit 505a-505c transmits its stored results in the slot designated to it in the broadcast in slot 1. It should further be appreciated that the measurement and the return of the data is decoupled in time. Measurement M will happen in frame F, and can either be returned in frame F, or it can be stored or placed in a buffer until a later frame. The data may not be returned until a later frame F+1 or greater.

In a more substantial example, there may be many hundreds of EDs on each RM branch. There may also be many RM units. TDMA packets incur an overhead in the form of a preamble, address, error checking and other non-payload data. For this reason, long packets with large payloads are more efficient. By having multiple RM/ED channels, many RM/ED data transfers can happen concurrently, increasing the communications efficiency. By collating the results at RM units 505a-505c, the subsequent RM/RD packet can comprise more data in a longer payload, increasing the communications efficiency. Furthermore, the example embodiments described herein maintain the deterministic protocol across all levels, as well as synchronisation across all levels with the use of distinct TDMA schedules on the different architectural levels.

There are many ways in which a frame can be structured. For example, a more complex TDMA timing diagram may be employed. Here the RM communications to RD unit 503 and ED are interleaved, to increase the throughput. It also incorporates slots for retries, and different responses from different nodes in different frames.

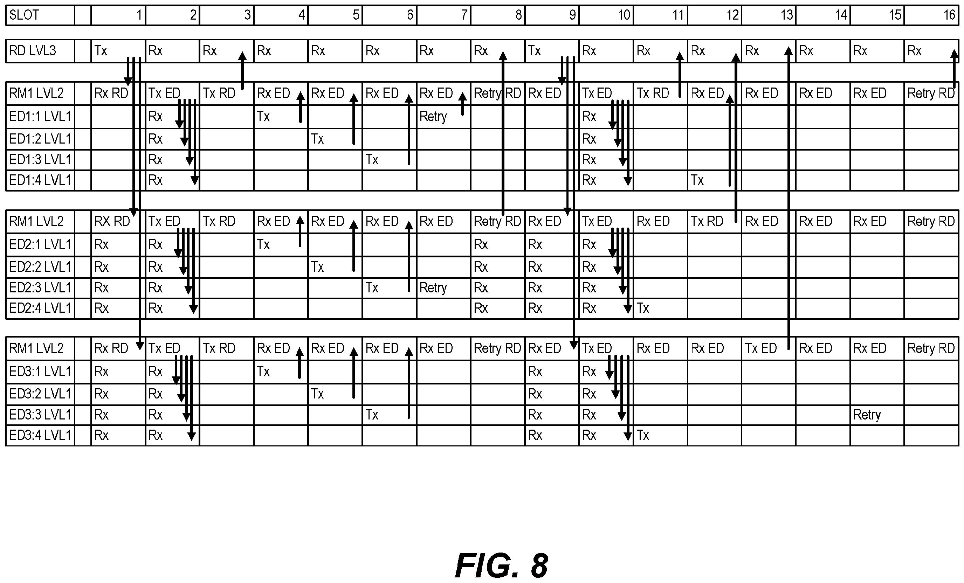

Figure 8 illustrates a more complex example. Slots 1-6 of Figure 8 are similar as to what was described in relation to Figure 7. Slot 7 of Figure 8 is used as a retry, where a previous transmitted packet failed to be received, perhaps because of corruption, and it is sent to a respective RM unit again. This demands a communications controller that can on a frame by frame basis reorder what is transmitted and when. The packet from ED1:1 sent to RM 505a in slot 7 may be a failed packet from a previous frame, while the retry for ED3:3 in slot 15 may have been for a failure in slot 6. Similarly, there may be retries for packets sent from RM units 505a-505c to RD unit 503. This is shown in slot 8 and slot 16. By providing sufficient retry slots, packets can be guaranteed to get through to an arbitrarily high probability.

According to some of the example embodiments, multiple frames may be combined into a super frame. Across a single super frame, all EDs may be communicated with, if required. In some networks, a single frame may be sufficient to communicate with all EDs, in larger networks, multiple frames may be required.

At the start of a frame, few or no assumptions may be made about the synchronisation of the clocks of all RM and ED nodes. There may well be a residual synchronisation of the clocks on all the nodes left over from the previous frame, but the clocks will diverge if not synchronised, and the spread will increase over time. Eventually, the nodes will be transmitting and receiving too early or too late, and measurements will be made at widely varying times.

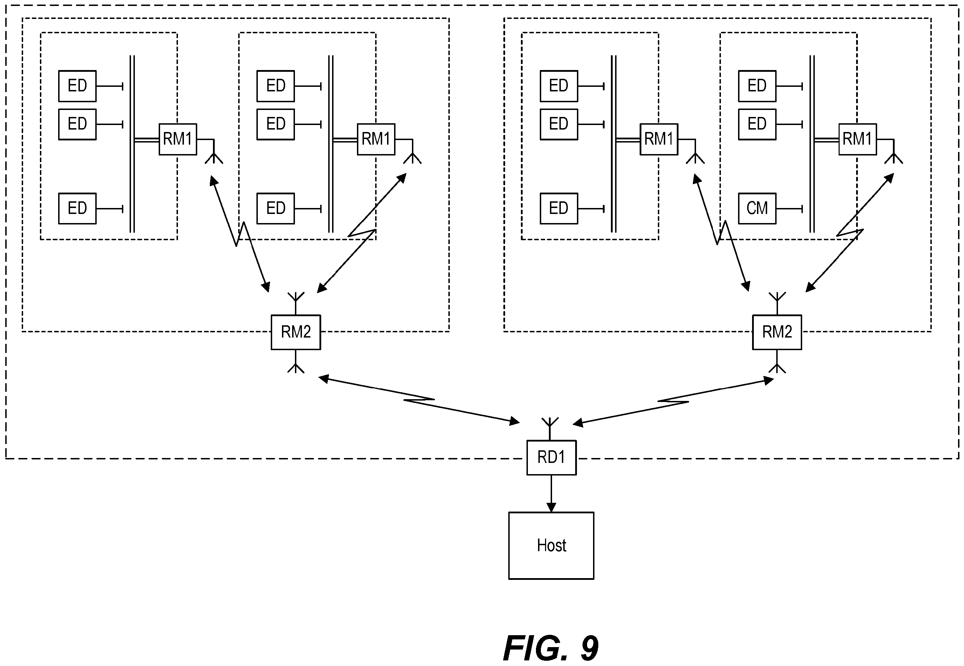

It should be appreciated while the system of Figure 5 features a three level architecture, such a configuration is merely an example. According to the example embodiments, multiple layers of RM units may be employed resulting in a communications system featuring more than three levels. Figure 9 provides an example of a communication system featuring 4 architectural levels. Specifically, the system of Figure 9 features a first level of various ED groupings and second level for first RM units (RM1), where one RM1 unit is associated with a respective ED grouping. The system of Figure 9 further comprises a third architecture level featuring a number of second RM units (RM2), where one RM2 unit is associated with a respective RM1 unit grouping. Finally, on a fourth architecture level a RD unit (RD1) is provided and is in direct communication with all of the RM2 units. It should be appreciated the system of Figure 9 is shown merely as an example and a communications system as described herein may include any number of architectural layers (i.e., any number of three or more layers). An arrangement such as the example illustrated in Figure 9, includes multiple levels which allows the communications architecture to match any arbitrary cell/module/pack architecture. It should be appreciated, according to some of the example embodiments, RM2 may manage a single pack (or any number of packs), rather than the multiple packs illustrated in the example provided in Figure 9.

The description of the example embodiments provided herein have been presented for purposes of illustration. The description is not intended to be exhaustive or to limit example embodiments to the precise form disclosed, and modifications and variations are possible in light of the above teachings or may be acquired from practice of various alternatives to the provided embodiments. The examples discussed herein were chosen and described in order to explain the principles and the nature of various example embodiments and its practical application to enable one skilled in the art to utilize the example embodiments in various manners and with various modifications as are suited to the particular use contemplated. The features of the embodiments described herein may be combined in all possible combinations of methods, apparatus, modules, systems, and computer program products. It should be appreciated that the example embodiments presented herein may be practiced in any combination with each other.

It should be noted that the word "comprising" does not necessarily exclude the presence of other elements or steps than those listed and the words "a" or "an" preceding an element do not exclude the presence of a plurality of such elements. It should further be noted that any reference signs do not limit the scope of the claims, that the example embodiments may be implemented at least in part by means of both hardware and software, and that several "means", "units" or "devices" may be represented by the same item of hardware.

The various example embodiments described herein are described in the general context of method steps or processes, which may be implemented in one aspect by a computer program product, embodied in a computer-readable medium, comprising computer-executable instructions, such as program code, executed by computers in networked environments. A computer-readable medium may comprise removable and non-removable storage devices comprising, but not limited to, Read Only Memory (ROM), Random Access Memory (RAM), compact discs (CDs), digital versatile discs (DVD), etc. Generally, program modules may comprise routines, programs, objects, components, data structures, etc. that perform particular tasks or implement particular abstract data types. Computer-executable instructions, associated data structures, and program modules represent examples of program code for executing steps of the methods disclosed herein. The particular sequence of such executable instructions or associated data structures represents examples of corresponding acts for implementing the functions described in such steps or processes.

In the drawings and specification, there have been disclosed example embodiments. However, many variations and modifications can be made to these embodiments. Accordingly, although specific terms are employed, they are used in a generic and descriptive sense only and not for purposes of limitation, the scope of the embodiments being defined by the following claims.

## Claims

1. A communications system for monitoring an electrical battery system, the communications system comprising:
a single Time-Division-Multiple-Access, TDMA, protocol operating across the communications system;
a plurality of electronic devices situated on a first level of the communications system, wherein each electronic device is configured to obtain measurements on at least one respective battery cell of the electrical battery system, said plurality of electronic devices being arranged in at least two subgroups of electronic devices;
at least two radio manager units situated on a second level of the communications system, wherein each subgroup of electronic devices is in communication with a respective radio manager unit via a first TDMA schedule and over a first communications medium;
at least one radio director unit situated on a third level of the communications system, wherein each radio manager unit and the at least one radio director unit are in communication via a second TDMA schedule and over a second communications medium;
wherein the at least one radio director unit is configured to determine the second TDMA schedule and each radio manager unit is configured to determine the respective first TDMA schedule, wherein said first and respective second TDMA schedules define a timing for measurement based reporting and instruction messaging throughout the communications system in a synchronized manner.

2. The communications system of claim 1, wherein the first and the second communications medium are equivalent or the first and second communications medium are distinct.

3. The communications system of claim 2, wherein the communications type is a far-field radio, near-field radio, optical, or electromagnetic medium.

4. The communications system of claim 3, wherein the first communications medium is a near-field radio and the second communications medium is a far-field radio.

5. The communications system of any of claims 1-4, wherein the at least one radio manager unit comprises a mechanism to switch between the first and second communications medium.

6. The communications system of claim 5, wherein the mechanism is an antenna switch.

7. The communications system of any of claims 1-6, wherein:
the at least one radio director unit is configured to transmit a broadcast message to each of the at least two radio manager units; and
each of the at least two radio manager units is configured to retrieve a respective portion of said broadcast message via a unique identifier associated with each radio manager unit.

8. The communications system of any of claims 1-7, wherein each of the plurality of electronic devices is configured to simultaneously measure a respective at least one battery cell according to the first TDMA schedule.

9. The communications system of any of claims 1-8, wherein the first TDMA schedule comprises at least one time frame for re-try measurements for any of the plurality of electronic devices.

10. The communications system of any of claims 1-9, wherein the communications system is comprised within an electric battery storage facility or within an electric vehicle.

11. A method in a communications system for monitoring an electrical battery system, the communications operating across a single Time-Division-Multiple-Access, TDMA, protocol, the method comprising:
determining a first TDMA schedule for communications, over a first communications medium, between a plurality of electronic devices and at least two radio manager units, wherein said plurality of electronic devices being situated on a first level of the communications system and being arranged in at least two subgroups of electronic devices, and wherein the at least two radio manager units situated on a second level of the communications medium;
determining a second TDMA schedule for communications, over a second communications medium, between the at least two radio manger units and at least one radio director unit, wherein the at least one radio director unit situated on a third level of the communications system;
obtaining, via the plurality of electronic devices, measurements on at least one respective battery cell of the electrical battery system;
transmitting, to at least two respective radio manager units, the obtained measurements the via the first TDMA schedule and over the first communications medium;
further transmitting, to the at least one radio director unit, the obtained measurements via the second TDMA schedule and over the second communications medium;
wherein the at least one radio director unit is configured to determine the second TDMA schedule and each radio manager unit is configured to determine the respective first TDMA schedule, wherein said first and respective second TDMA schedules define a timing for measurement based reporting and instruction messaging throughout the communications system in a synchronized manner.

12. The method of claim 11, further comprising switching, within the at least two radio manager units, between the first and second communications medium.

13. The method of any of claims 11-12, the method further comprising:
transmitting, via the at least one radio director unit, a broadcast message to each of the at least two radio manager units; and
retrieving, via each of the at least two radio manager units, a respective portion of said broadcast message via a unique identifier associated with each radio manager unit.

14. The method of any of claims 11-13, wherein the obtaining measurements further comprises simultaneously measuring, via the plurality of electronic devices, a respective at least one battery cell according to the first TDMA schedule.

15. A computer-readable medium storing instructions which, when executed by a processor of a communications system for an electronic battery system, cause the communications system to execute the method according to any one of claims 11-14.
